# EUROPEAN PATENT SPECIFICATION

(11) **EP 3 652 789 B1**
(45) Date of publication and mention of the grant of the patent: **21.09.2022**
(21) Application number: 17825958.6
(22) Date of filing: 14.12.2017
(51) Int. Cl.: H01L 31/0224, H01L 31/068, H01L 31/18

(54) **FLEXIBLE SOLAR CELL AND METHOD**
FLEXIBLE SOLARZELLE UND VERFAHREN
CELLULE SOLAIRE FLEXIBLE ET PROCÉDÉ

(30) Priority: 14.07.2017 US 201762532460 P
(43) Date of publication of application: 20.05.2020
(73) Proprietor: King Abdullah University Of Science And Technology, Thuwal 23955-6900 (SA)
(72) Inventor: HUSSAIN, Muhammad Mustafa, Thuwal 23955-6900 (SA); BAHABRY, Rabab Riyad, Thuwal 23955-6900 (SA)
(74) Representative: Ipsilon
(86) International application number: PCT/IB2017/057960
(87) International publication number: WO 2019/012323

(56) References cited:
- US-A1- 2015 171 240
- 27TH EUROPEAN PHOTOVOLTAIC SOLAR ENERGY CONFERENCE, PROCEEDINGS OF THE 27TH INTERNATIONAL CONFERENCE, WIP-RENEWABLE ENERGIES, SYLVENSTEINSTR. 2 81369 MUNICH, GERMANY, 31 October 2012 (2012-10-31), XP040634192, ISBN: 978-3-936338-28-7
- JOSE L CRUZ-CAMPA ET AL: "Ultrathin Flexible Crystalline Silicon: Microsystems-Enabled Photovoltaics", IEEE JOURNAL OF PHOTOVOLTAICS, I E E E, US, vol. 1, no. 1, 1 July 2011 (2011-07-01), pages 3-8, XP011387321, ISSN: 2156-3381, DOI: 10.1109/JPHOTOV.2011.2162973

## Description

### BACKGROUND

### TECHNICAL FIELD

Embodiments of the subject matter disclosed herein generally relate to a flexible solar cell and method for making a flexible solar cell.

### DISCUSSION OF THE BACKGROUND

Increasing concerns about the environmental impact of so-called dirty energy sources, such as carbon-based energy source, has resulted in tremendous advancements in solar energy collection using solar cells. For example, the first useful silicon-based solar cell was approximately six percent efficient, whereas some modern solar cells can achieve almost thirty percent efficiency.

This increased solar cell efficiency has led to research into new applications for solar cells, such as powering wearable and implantable electronics, powering robotics, being applied to infrastructure and vehicles, etc. Whereas conventional solar cells are quite rigid, it is desirable for solar cells to be more flexible for these new applications.

One type of flexible solar cell is a thin-film silicon-based solar cell, which is particularly advantageous due to its low weight. These thin-film silicon-based solar cells exhibit a significant reduction in optical absorption compared to conventional rigid solar cells, which is due to the small active silicon material in the thin-film silicon-based solar cells compared to rigid solar cells, which have a significantly thicker silicon energy collecting portion.

There are currently two main approaches being explored for the production of flexible silicon-based solar cells. The first approach called thin film solar cells (TFSCs) and is being extensively investigated in the academic research. Although TFSCs can reduce the total material cost and eventually the installation cost, manufacturing highly efficient TFSCs remains challenging. In general, the fabricating process of highly efficient silicon-based solar cells is not compatible with the thermal, chemical and mechanical properties of the resilient substrates. The flexible TFSCs can be prepared by transfer printing techniques such as the transfer using a porous silicon layer, sacrificial layer, controlled crack and water-assisted thin-film delamination. This approach results in reduced solar cell performance because production temperatures are limited to the maximum temperature of the substrate materials.

The second approach is used in the industrial field to assemble semi-flexible solar panels. In this approach, a rigid fabricated solar cell is cut into a plurality of individual solar cells, which are assembled on a semi-flexible substrate. The plurality of individual solar cells are then electrically connected using a metal interconnection to form a solar panel. Although this approach addresses the substrate thermal incompatibility of the first approach, the second approach suffers from low throughput and high cost. Specifically, the second approach only provides limited flexibility and requires additional steps to arrange the plurality of solar cells on the resilient substrate and to electrically interconnect the plurality of solar cells. The second approach also typically involves conventional vertical junction solar cells and typically results in a solar array having a thickness in the millimeter range, e.g., approximately 2.5 mm.

The article "Ultrathin and Flexible Single Crystal Silicon Mini-Modules" by Cruz-Campa et al. discloses a flexible solar cell with an interdigitated back contact. Flexibility is achieved by providing ultrathin mini cells arranged on flexible substrates. Passivation and metallization of the cells is performed on wafers having a standard thickness, and the cells are then separated and transferred to the flexible substrate.

The article "Ultrathin Flexible Crystalline Silicon: Microsystems-Enabled Photovoltaics" by Cruz-Campa et al. describes a process of making the mini solar cells discussed in the Cruz-Campa article referenced in the preceding paragraph.

US 2015/171240 A1 discloses processing interdigitated subs-cells from a single wafer. Flexibility is achieved by thinning the cells and transferring the thinned cells to flexible back sheets.

Thus, there is a need for flexible solar cells and methods of producing flexible solar cells that do not suffer from reduced solar cell performance requirements due to temperature limitations during production and also can be produced with a higher throughput and lower cost than the second approach.

### SUMMARY

According to an embodiment, there is a flexible solar cell, which includes an interdigitated back contact having a first electrode coupled to a first plurality of contacts and a second electrode coupled to a second plurality of contacts. The first plurality of contacts run in a first direction from the first electrode towards the second electrode and the second plurality of contacts run in a second direction from the second electrode towards the first electrode. The flexible solar cell also includes a plurality of light-collecting segments coupled to the first and second plurality of contacts of the interdigitated back contact. Adjacent ones of the plurality of light-collecting segments are spaced apart from each other in the first or second direction. A length of each of the plurality of light-collecting segments runs along the interdigitated back contact in a third direction, which is perpendicular to the first and second directions.

According to another embodiment, there is a method of making a flexible solar cell. A rigid solar cell is provided. The rigid solar cell comprises an interdigitated back contact and a light-collecting substrate arranged on top of the interdigitated back contact. A plurality of channels are formed in the light-collecting substrate. The plurality of channels expose portions of the interdigitated back contact and the plurality of channels run in a direction perpendicular to a direction in which contacts of the interdigitated contact run.

### BRIEF DESCRIPTION OF THE DRAWINGS

The accompanying drawings, which are incorporated in and constitute a part of the specification, illustrate one or more embodiments and, together with the description, explain these embodiments. In the drawings:
Figure 1 is a schematic diagram of a flexible solar cell according to an embodiment;
Figures 2A-2D illustrate a plurality of shapes for a flexible solar cell according to an embodiment;
Figure 3 is a flowchart of a method of making a flexible solar cell according to an embodiment;
Figure 4 is another flowchart of a method of making a flexible solar cell according to an embodiment;
Figures 5A-5F are schematic diagrams of a method of making a flexible solar cell according to an embodiment; and
Figure 6 is a flowchart of part of a method of making a flexible solar cell according to an embodiment.

### DETAILED DESCRIPTION

The following description of the exemplary embodiments refers to the accompanying drawings. The same reference numbers in different drawings identify the same or similar elements. The following detailed description does not limit the invention. Instead, the scope of the invention is defined by the appended claims. The following embodiments are discussed, for simplicity, with regard to the terminology and structure of a flexible solar cell.

Reference throughout the specification to "one embodiment" or "an embodiment" means that a particular feature, structure or characteristic described in connection with an embodiment is included in at least one embodiment of the subject matter disclosed. Thus, the appearance of the phrases "in one embodiment" or "in an embodiment" in various places throughout the specification is not necessarily referring to the same embodiment. Further, the particular features, structures or characteristics may be combined in any suitable manner in one or more embodiments.

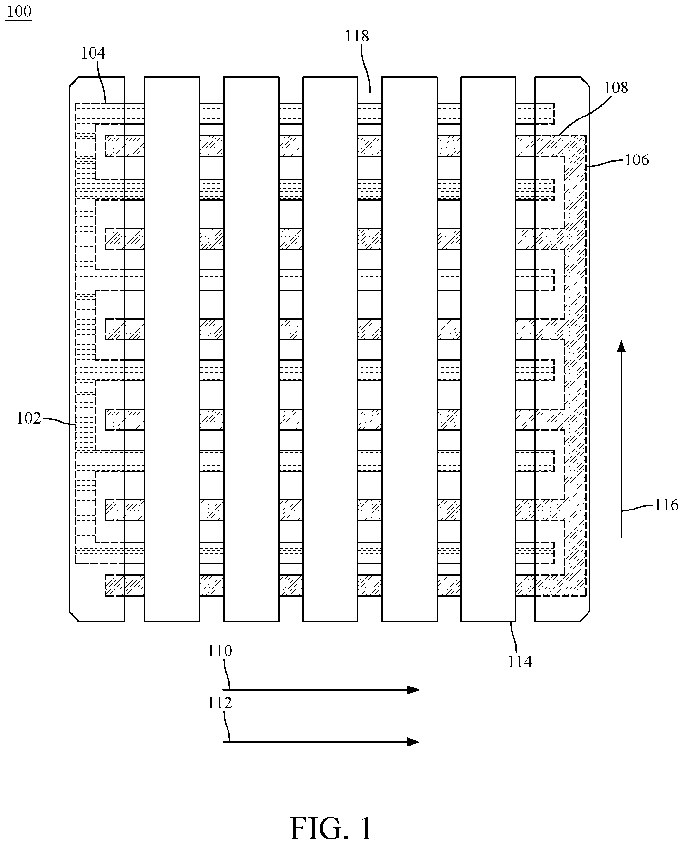

Referring now to Figure 1, a flexible solar cell 100 includes an interdigitated back contact. The interdigitated back contact includes a first electrode 102 coupled to a first plurality of contacts 104 (only one of which is labeled for sake of clarity) and a second electrode 106 coupled to a second plurality of contacts 108 (only one of which is labeled for sake of clarity). The first plurality of contacts 104 run in a first direction 110 from the first electrode 102 towards the second electrode 106 and the second plurality of contacts 108 run in a second direction 112 from the second electrode 106 towards the first electrode 102. The flexible solar cell also includes a plurality of light-collecting segments 114 (only one of which is labeled for sake of clarity) coupled to the first 104 and second 108 plurality of contacts of the interdigitated back contact. Adjacent ones of the plurality of light-collecting segments 114 are spaced apart from each other in the first 110 or second direction 112. A length of each of the plurality of light-collecting segments 114 runs along the interdigitated back contact in a third direction 116, which is perpendicular to the first 110 and second 112 directions.

As used herein, a light-collecting segment is a device that transforms electromagnetic radiation (e.g., solar radiation) into electrical current. The plurality of light-collecting segments 114 are spaced apart from each other by channels 118, which expose portions of the interdigitated back contact 102. In one embodiment, in which the flexible solar cell is in the form of a square with five inch (i.e., 127 mm) sides, the width of the light-collecting segments at the edges of the solar cell can be, for example, 8.81 mm, the width of the light-collecting segments between the edge segments can be, for example, 6.19 mm, and the width of the channels 118 can be, for example, 0.86 mm. These dimensions are merely exemplary and other dimensions can be employed.

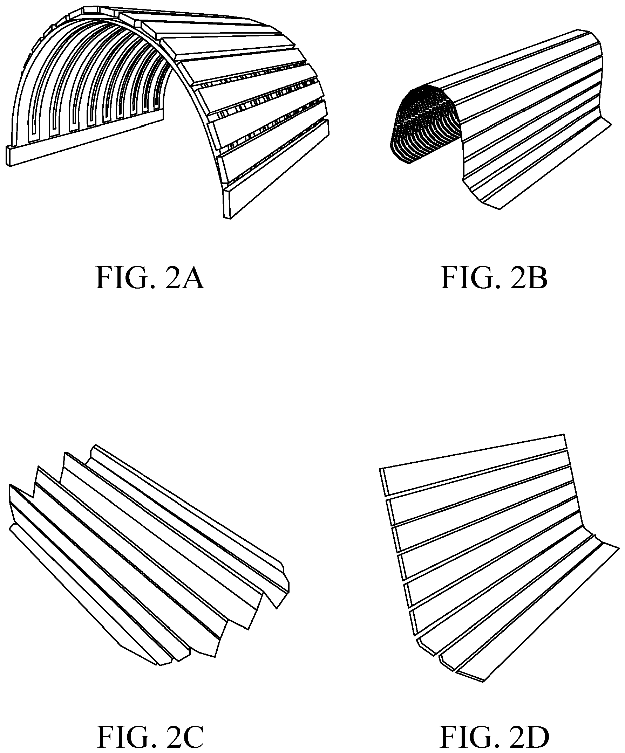

The channels 118 allow the solar cell 100 to flex due to the flexibility of the interdigitated back contact. Thus, for example, as illustrated in Figures 2A and 2B, the flexible solar cell 100 can have a curved shape. The flexible solar cell can achieve other shapes, such as a zig-zag shape in Figure 2C or a bi-facial shape in Figure 2D, i.e., having a first portion of the plurality of light-collecting segments 114 facing one direction and a second portion of the plurality of light-collecting segments 114 facing a second direction. The zig-zag shape in Figure 2C can involve, for example, a bending angle of 71.4°. The bi-facial shape in Figure 2D can involve, for example a bending radius < 140 µm. The particular shapes illustrated in Figures 2A-2D are for purposes of explanation and not limitation, and the flexible solar cell 100 can form other shapes.

The flexible solar cell 100 opens up new applications for solar cells that previously would not have been considered in connection with rigid solar cells. For example, the flexible solar cell arranged in the curved shape illustrated in Figure 2A can be applied to a corresponding curved surface, which can serve as a supporting substrate protecting the flexible solar cell 100 from damage. In contrast, conventional rigid solar cells would either require an additional rigid substrate on the back side of the interdigitated back contact to provide additional support to the portions of the rigid solar cell that are not in contact with a curved surface or would require using smaller solar cells, which would increase production time and costs because multiple, smaller solar cells would each require their own interdigitated back contact.

The interdigitated back contact is particularly advantageous for solar cells because it increases the light-collecting area of the solar cell, whereas various front contact arrangements reduce the light-collecting area because the contacts are obscure portions of the side of the light-collecting substrate intended to be impinged upon by light. The interdigitated contact forms the energy collecting portion of the solar cell. Specifically, one electrode and plurality of contacts form a positive electrical contact and the other electrode and plurality of contacts form a negative electrical contact. Thus, the one electrode and plurality of contacts forming the positive electrical contact can be p-doped and the other electrode and plurality of contacts forming the negative electrical contact can be n-doped. The electrodes 102 and 106 and the plurality of contacts 104 and 108 can be formed from aluminum, which provides great flexibility to the flexible solar cell 100. For example, an interdigitated back contact formed from screen-printed aluminum can have a strain percentage greater that 20%.

The use of a solar cell with an interdigitated back contact also simplifies the production process because it avoids expensive lithography techniques for silicon forming that are required to avoid handling the contacts.

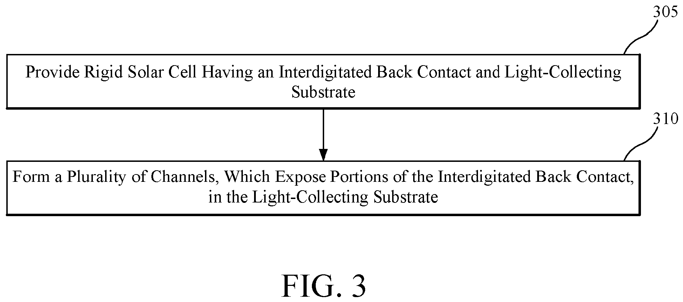

Figure 3 is a flowchart of a method of making a flexible solar cell. Initially, a rigid solar cell is provided (step 305). In one embodiment, the rigid solar cell has, for example, a square shape with 12.7 cm (5 inch) sides. The rigid solar cell includes an interdigitated back contact and a light collecting substrate arranged on top of the interdigitated back contact. The interdigitated back contact includes interdigitated p-doped and n-doped regions, as well as positive and negative electrodes, which can be, for example, 0.42 mm and 1.6 mm wide, respectively. In one embodiment, the light collecting substrate can have a thickness of approximately 260 µm.

Next, a plurality of channels 118 are formed in the light-collecting substrate (step 310). The plurality of channels expose portions of the interdigitated back contact and run in the third direction 116, which is perpendicular to the first 110 and second 112 directions. The resulting structure is the flexible solar cell 100 of Figure 1.

A flexible solar cell produced by forming a plurality of channels in a rigid solar cell having an interdigitated back contact provides a number of advantages over conventional flexible solar cells. Specifically, the disclosed solar cell employs the interdigitated back as both the electrical interconnection between individual light-collecting segments and as a carrier for the individual light-collecting segments, and thus avoids the need for additional steps of placing individual solar cells on a resilient substrate and then electrically interconnecting the individual solar cells required to produce conventional solar cells. Further, the light collecting substrate can have a thickness of approximately 260 µm, whereas conventional flexible solar cells typically have thicknesses of approximately 2.5 mm. This reduced thickness allows the disclosed flexible solar cell to be used in a wider variety of applications.

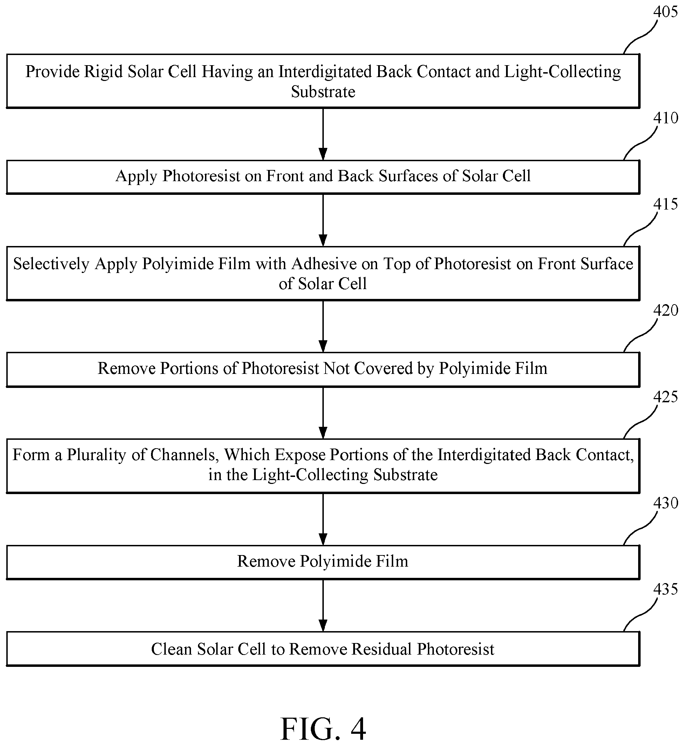

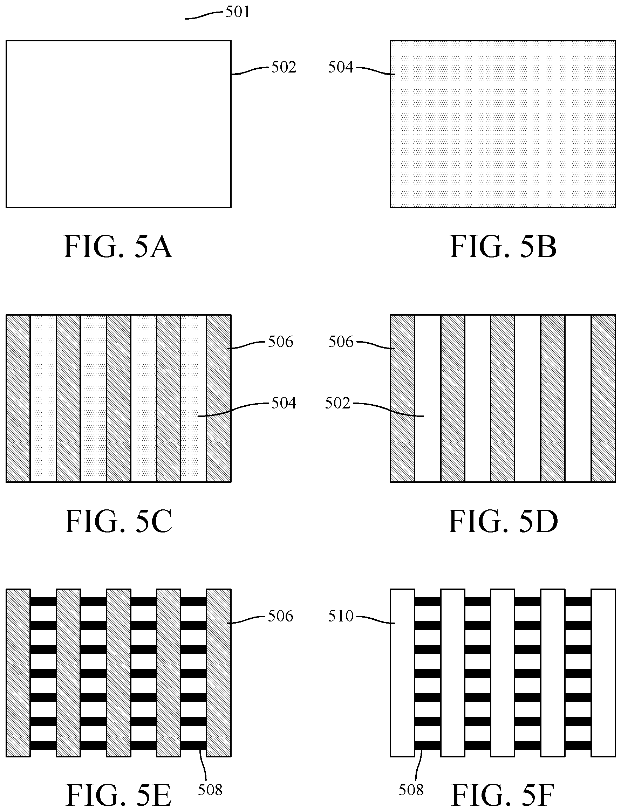

Figure 4 is a flowchart of a method of making a flexible solar cell, which provides more details of the method, which will be described in connection with Figures 5A-5F. Initially, a rigid solar cell 501 having an interdigitated back contact (not illustrated) and a light-collecting substrate 502 are provided (step 405 and Figure 5A). A photoresist 504 is applied on the front and back surfaces of the solar cell 501 (step 410 and Figure 5B). This can involve, for example, spinning positive photoresist 9260 (from MicroChemicals) on the front surface at 2,4000 rpm for 60 seconds followed by a pyrolysis bake at 110° C for 180 seconds. The spinning and pyrolysis bake can then be repeated for the back surface of the solar cell 501. The photoresist layer simplifies the subsequent removal of the polyimide film with minimal residues on the active solar area.

A polyimide film 506 with an adhesive backing is selectively applied on top of the photoresist 504 on the front side of the rigid solar cell 501 (step 415 and Figure 5C). The areas having the polyimide film 506 approximately correspond to those areas of the light-collecting substrate 502 that will remain when the process is completed. The polyimide film 506 can be, for example, a 6.35 mm (¼ inch) polyimide film with silicon adhesive, such as double layer Kapotin tape. As illustrated, the polyimide film 506 is applied in parallel lines that are perpendicular to the direction of the contacts of the interdigitated back contact. In one embodiment, this can involve fifteen lines of approximately 6.24 mm wide polyimide film across the front surface of the solar cell with an approximately 1 mm gap between adjacent polyimide films. Further, wide polyimide film, for example having a width of approximately 8.81 mm, can be located at the edges of the front surface of the solar cell to prevent thinning of the silicon located on top of the first and second electrodes.

Portions of the photoresist 504 not covered by the polyimide film 506 are then removed (step 420 and Figure 5D). This can involve, for example, exposing the solar cell to a broadband stepper at 1800 mJ/cm² followed by development using AZ 726 MIF (from MicroChemicals GmbH) for 6 minutes. It will be recognized that AZ 726 MIF is 2.38% TMAH in H2O with surfactants added for substrate wetting and additives for removable of photoresist residuals remaining after development.

A plurality of channels are formed in the light-collecting substrate 502 so as to expose portions of the interdigitated back contact 508 (step 425 and Figure 5E). The channels can be formed, for example, using a deep reactive-ion etching (DRIE) process from the front surface of the solar cell, which can include an anti-reflective coating (ARC) SiN layer. This can involve, for example, using the Bosch process of approximately 650 cycles of successive deposition and etching using cryogenic cooling at -20° C to obtain smooth sidewalls for the channels. The initial Ar plasma strike can be performed by flowing 10 sccm C₄F₈, 20 sccm SF₆, and 50 sccm Ar at 15mTorr, 2000 W inductively coupled plasma (ICP), and 20 RF for 10 seconds. The principle etching of the Si surface takes the form of the following reaction:

*SF₆* + *e⁻* → *SF*₄ + *3F* + *e⁻* (1)

*Si*_{(*solid*)} + 4F → (*SiF₃*)_{(*gas*)} (2)

The deposition can involve 100 sccm C₄F₈ and 5 sccm SF₆ at 30 mTorr, 1300 W ICP, and 5 W RF for 3 seconds and the etching can involve 5 sccm C₄F₈ and 100 sccm SF₆ at 30 mTorr, 1300 W ICP, and 35 W RF for 8 seconds. The plasma polymerization reaction is:

*C*₄*F*₈ + *e⁻* → 2*C*₂*F*₄ → *CF*₂ → *CF*₃ (3)

*C*₂*F*₄, *CF*₂ → (*CF*)*ₓ* (4)

The polyimide film 506 is then removed (step 430 and Figure 5F) and the solar cell is cleaned to remove the residual photoresist and any remaining adhesive that was underneath the polyimide film 506 (step 435). The solar cell can be cleaned using, for example, acetone and isopropyl alcohol (IPA).

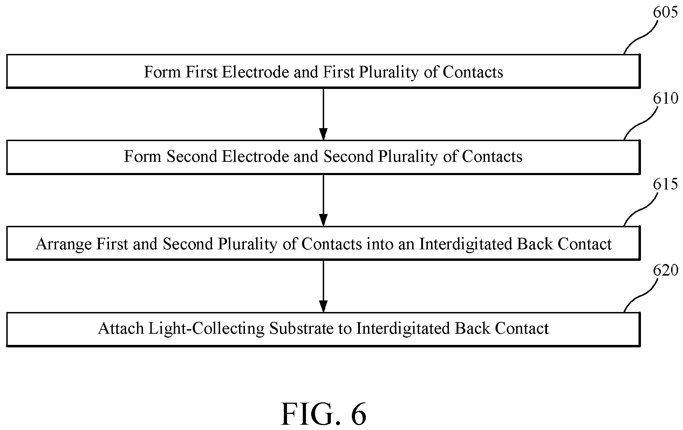

The method described above in connection with Figures 3, 4, and 5A-5F involved using a pre-fabricated rigid solar cell having an attached interdigitated back contact, which is particularly advantageous because conventional pre-fabricated rigid solar cells can be used to form the flexible solar cell without requiring the time, expense, and facilities to produce the rigid solar cell. The present invention, however, can also be employed to first produce the rigid solar cell and then use it to produce the flexible solar cell. Thus, a method for producing the rigid solar cell is illustrated in Figure 6. Initially, the first electrode and first plurality of contacts are formed (step 605) and the second electrode and second plurality of contacts are formed (step 610). This can involve screen-printing aluminum into the desired geometry for the first and second electrodes and contacts. This can also involve n-doping one of the electrodes and the plurality of contacts and p-doping the other of the electrodes and the plurality of contacts. The order of these two steps can be reversed or these steps can be performed in parallel.

The first and second plurality of contacts are then arranged to form an interdigitated back contact (step 615) and the light-collecting substrate is attached to the interdigitated back contact (step 620). Thus, the method of Figure 6 can replace step 405 in Figure 4 and step 505 in Figure 5 as a way to provide a rigid solar cell having an interdigitated back contact and light-collecting substrate.

Testing of a 127×127 mm² flexible solar cell produced in the manner disclosed above demonstrated a 17.2% power conversion efficiency. The flexible solar cell benefits from the fact that the active silicon thickness is preserved (240 µm thick in the tested flexible solar cell). The flexible solar cell demonstrated high flexibility having a bending radius lower than 140 µm and a high stability over 1,000 bending cycles, which included convex bending, concave bending, zigzag bending, and bifacial bending.

A comparison was performed of the performance of a 15×127 mm² c-Si rigid solar cell with flexible solar cell made from a 15×127 mm² c-Si rigid solar cell, which produced the following results:

| | Rigid Solar Cell | Flexible Solar Cell |
|---|---|---|
| Average Open Circuit Voltage (V_{oc}) | 0.6200 ± 0.02 V | 0.6200 ± 0.02 V |
| Short-Circuit Current Density (J_{sc}) | 38.607 ± 1.2 mA/cm² | 38.055 ± 1.2 mA/cm² |
| Fill Factor (FF) | 71.9413 ± 1.5% | 72.0139 ± 1.5% |
| Power Conversion Efficiency (η) | 17.294 ± 0.8% | 17.017 ± 0.8% |
| Power Density (P) | 17.30 mW/cm² | 17.00 mW/cm² |
| Total Power Generated (Mw) | 328 mW | 283 mW |
| Weight (g) | 1.5 g | 1.3 g |

Thus, the disclosed flexible solar cell performs similarly to a rigid solar cell. The flexible solar cell produces 13.7% less total power than the rigid solar cell but is also 13.3% lighter than the rigid solar cell. Further, because the flexibility is achieved by creating channels between light collecting substrate segments instead of thinning the light collecting substrate as in conventional thin-film silicon-based flexible solar cells, the disclosed solar cell achieves greater efficiency than the conventional thin-film silicon-based flexible solar cell due to the thicker light collecting substrate.

The flexible solar cell can be coupled to provide power to any type of electrical consumer, such as a light-emitting diode (LED), battery, circuit, device, etc.

The disclosed embodiments provide a flexible solar cell and method of making flexible solar cell. It should be understood that this description is not intended to limit the invention. On the contrary, the exemplary embodiments are intended to cover alternatives, modifications and equivalents, which are included in the spirit and scope of the invention as defined by the appended claims. Further, in the detailed description of the exemplary embodiments, numerous specific details are set forth in order to provide a comprehensive understanding of the claimed invention. However, one skilled in the art would understand that various embodiments may be practiced without such specific details.

Although the features and elements of the present exemplary embodiments are described in the embodiments in particular combinations, each feature or element can be used alone without the other features and elements of the embodiments or in various combinations with or without other features and elements disclosed herein.

This written description uses examples of the subject matter disclosed to enable any person skilled in the art to practice the same, including making and using any devices or systems and performing any incorporated methods. The patentable scope of the subject matter is defined by the claims, and may include other examples that occur to those skilled in the art. Such other examples are intended to be within the scope of the claims.

## Claims

1. A flexible solar cell (100), comprising:
an interdigitated back contact (508), comprising a first electrode (102) coupled to a first plurality of contacts (104) and a second electrode (106) coupled to a second plurality of contacts (108), wherein the first plurality of contacts (104) run in a first direction (110) from the first electrode (102) towards the second electrode (106) and the second plurality of contacts (108) run in a second direction (112) from the second electrode (106) towards the first electrode (102), **characterized by**
a plurality of light-collecting segments (114) coupled to the first (104) and second (108) plurality of contacts of the interdigitated back contact (508),
wherein adjacent ones of the plurality of light-collecting segments (114) are spaced apart from each other in the first (110) or second (112) direction, and
wherein a length of each of the plurality of light-collecting segments (114) runs along the interdigitated back contact (508) in a third direction (116), which is perpendicular to the first (110) and second directions (112).

2. The flexible solar cell of claim 1, wherein the first plurality of contacts (104) are n-doped negative contacts and the second plurality of contacts are p-doped positive contacts.

3. The flexible solar cell of claim 1, wherein the plurality of light-collecting segments (114) are mono-crystalline silicon.

4. The flexible solar cell of claim 1, wherein the flexible solar cell (100) has a zigzag shape in the first or second direction.

5. The flexible solar cell of claim 1, wherein the flexible solar cell (100) has a bifacial shape in the first or second direction.

6. The flexible solar cell of claim 1, wherein the flexible solar cell (100) has a curved shape.

7. The flexible solar cell of claim 1, wherein the interdigitated back contact (508) is screen-printed aluminum.

8. The flexible solar cell of claim 1, wherein the interdigitated back contact (508) has a strain percentage greater than 20%.

9. The flexible solar cell of claim 1, wherein the plurality of light-collecting segments (114) include a first outermost light-collecting segment and a second outermost light-collecting segment, wherein some of the plurality of light-collecting segments have a rectangular shape and the first and second outermost light-collecting segments have a shape of a rectangle with two corners having a diagonal shape.

10. A method of making a flexible solar cell, the method comprising:
providing (305, 405) a rigid solar cell (501), which comprises an interdigitated back contact (508) and a light-collecting substrate (502) arranged on top of the interdigitated back contact (508), **characterized by**
forming (310, 425) a plurality of channels (118) in the light-collecting substrate (502),
wherein the plurality of channels (118) expose portions of the interdigitated back contact (508) and the plurality of channels (118) run in a direction (116) perpendicular to a direction (110, 112) in which contacts of the interdigitated contact run.

11. The method of claim 10, wherein prior to forming the plurality of channels (118), the method comprises:
applying a photoresist on front and back surfaces of the rigid solar cell (501); and
applying a film in the third direction on top of the photoresist on the front surface of the rigid solar cell.

12. The method of claim 11, wherein prior to forming the plurality of channels (118), the method further comprises:
removing portions of the photoresist not covered by the film.

13. The method of claim 11, further comprising:
removing the film after forming the plurality of channels (118).

14. The method of claim 13, further comprising:
cleaning residual photoresist from the solar cell after removing the film.

15. The method of claim 10, wherein the interdigitated back contact (508)
is screen-printed aluminum.

## Patentansprüche

1. Flexible Solarzelle (100), umfassend:
einen interdigitalen Rückkontakt (508), der eine erste Elektrode (102), die mit einer Mehrzahl von Kontakten (104) gekoppelt ist, und eine zweite Elektrode (106) umfasst, die mit einer zweiten Mehrzahl von Kontakten (108) gekoppelt ist, wobei die erste Mehrzahl von Kontakten (104) in einer ersten Richtung (110) von der ersten Elektrode (102) zur zweiten Elektrode (106) verläuft, und die zweite Mehrzahl von Kontakten (108) in einer zweiten Richtung (112) von der zweiten Elektrode (106) zur ersten Elektrode (102) verläuft, **gekennzeichnet durch**
eine Mehrzahl von lichtsammelnden Segmenten (114), die mit der ersten (104) und der zweiten (108) Mehrzahl von Kontakten des interdigitalen Rückkontakts (508) gekoppelt ist, wobei
benachbarte der Mehrzahl von lichtsammelnden Segmenten (114) voneinander in der ersten (110) oder der zweiten (112) Richtung beabstandet sind, und wobei
eine Länge jedes der Mehrzahl von lichtsammelnden Segmenten (114) in einer dritten Richtung (116), die senkrecht zu der ersten (110) und der zweiten Richtung (112) ist, entlang des interdigitalen Rückkontakts (508) verläuft.

2. Flexible Solarzelle nach Anspruch 1, wobei es sich bei der ersten Mehrzahl von Kontakten (104) um n-dotierte negative Kontakte handelt und es sich bei der zweiten Mehrzahl von Kontakten um p-dotierte positive Kontakte handelt.

3. Flexible Solarzelle nach Anspruch 1, wobei es sich bei der Mehrzahl von lichtsammelnden Segmenten (114) um monokristallines Silizium handelt.

4. Flexible Solarzelle nach Anspruch 1, wobei die flexible Solarzelle (100) in der ersten oder der zweiten Richtung eine Zickzackform aufweist.

5. Flexible Solarzelle nach Anspruch 1, wobei die flexible Solarzelle (100) in der ersten oder der zweiten Richtung eine bifaziale Form aufweist.

6. Flexible Solarzelle nach Anspruch 1, wobei die flexible Solarzelle (100) eine Kurvenform aufweist.

7. Flexible Solarzelle nach Anspruch 1, wobei der interdigitale Rückkontakt (508) mit Siebdruck bedrucktes Aluminium ist.

8. Flexible Solarzelle nach Anspruch 1, wobei der interdigitale Rückkontakt (508) einen Spannungsprozentsatz von über 20 % aufweist.

9. Flexible Solarzelle nach Anspruch 1, wobei die Mehrzahl von lichtsammelnden Segmenten (114) ein erstes äußerstes lichtsammelndes Segment und ein zweites äußerstes lichtsammelndes Segment umfasst, wobei einige der Mehrzahl von lichtsammelnden Segmenten eine rechteckige Form aufweisen, und das erste und das zweite äußerste lichtsammelnde Segment eine Form eines Rechtecks mit zwei Ecken mit einer diagonalen Form aufweisen.

10. Verfahren zur Herstellung einer flexiblen Solarzelle, wobei das Verfahren umfasst:
Bereitstellen (305, 405) einer starren Solarzelle (501), die einen interdigitalen Rückkontakt (508) und ein lichtsammelndes Substrat (502) umfasst, das auf dem interdigitalen Rückkontakt (508) angeordnet ist, **gekennzeichnet durch**
Bilden (310, 425) einer Mehrzahl von Kanälen (118) im lichtsammelnden Substrat (502), wobei
die Mehrzahl von Kanälen (118) Abschnitte des interdigitalen Rückkontakts (508) freilegt, und die Mehrzahl von Kanälen (118) in einer Richtung (116) senkrecht zu einer Richtung (110, 112) verläuft, in welcher Kontakte des interdigitalen Rückkontakts verlaufen.

11. Verfahren nach Anspruch 10, wobei das Verfahren vor dem Bilden der Mehrzahl von Kanälen (118) umfasst:
Auftragen eines Fotolacks auf die vordere und die hintere Oberfläche der starren Solarzelle (501); und
Auftragen eines Films in der dritten Richtung auf den Fotolack auf der vorderen Oberfläche der starren Solarzelle.

12. Verfahren nach Anspruch 11, wobei das Verfahren vor dem Bilden der Mehrzahl von Kanälen (118) ferner umfasst:
Entfernen von Abschnitten des Fotolacks, die nicht vom Film bedeckt sind.

13. Verfahren nach Anspruch 11, ferner umfassend:
Entfernen des Films nach dem Bilden der Mehrzahl von Kanälen (118).

14. Verfahren nach Anspruch 13, ferner umfassend:
Reinigen der Solarzelle von Restfotolack nach dem Entfernen des Films.

15. Verfahren nach Anspruch 10, wobei der interdigitale Rückkontakt (508) mit Siebdruck bedrucktes Aluminium ist.

## Revendications

1. Cellule solaire flexible (100) comprenant :
un contact arrière interdigité (508) comprenant une première électrode (102) couplée à une première pluralité de contacts (104) et une deuxième électrode (106) couplée à une deuxième pluralité de contacts (108), dans laquelle la première pluralité de contacts (104) s'étendent dans une première direction (110) de la première électrode (102) vers la deuxième électrode (106) et la deuxième pluralité de contacts (108) s'étendent dans une deuxième direction (112) de la deuxième électrode (106) vers la première électrode (102), **caractérisée par** :
une pluralité de segments collecteurs de lumière (114) couplés aux première (104) et deuxième (108) pluralités de contacts du contact arrière interdigité (508),
dans laquelle des segments de la pluralité de segments collecteurs de lumière (114) sont espacés entre eux dans les première (110) ou deuxième (112) directions, et
dans laquelle une longueur de chacun de la pluralité de segments collecteurs de lumière (114) s'étend le long du contact arrière interdigité (508) dans une troisième direction (116) perpendiculaire aux première (110) et deuxième (112) directions.

2. Cellule solaire flexible selon la revendication 1, dans laquelle la première pluralité de contacts (104) sont des contacts négatifs dopés n et la deuxième pluralité de contacts sont des contacts positifs dopés p.

3. Cellule solaire flexible selon la revendication 1, dans laquelle la pluralité de segments collecteurs de lumière (114) sont constitués de silicium monocristallin.

4. Cellule solaire flexible selon la revendication 1, dans laquelle la cellule solaire flexible (100) présente une forme en zigzag dans la première ou deuxième direction.

5. Cellule solaire flexible selon la revendication 1, dans laquelle la cellule solaire flexible (100) présente une forme bifaciale dans la première ou deuxième direction.

6. Cellule solaire flexible selon la revendication 1, dans laquelle la cellule solaire flexible (100) présente une forme incurvée.

7. Cellule solaire flexible selon la revendication 1, dans laquelle le contact arrière interdigité (508) est constitué d'aluminium sérigraphié.

8. Cellule solaire flexible selon la revendication 1, dans laquelle le contact arrière interdigité (508) présente un pourcentage de déformation supérieur à 20 %.

9. Cellule solaire flexible selon la revendication 1, dans laquelle la pluralité de segments collecteurs de lumière (114) comprennent un premier segment collecteur de lumière externe et un deuxième segment collecteur de lumière externe, dans laquelle certains de la pluralité de segments collecteurs de lumière présentent une forme rectangulaire et les premier et deuxième segments collecteurs de lumière externes présentent la forme d'un rectangle avec deux angles ayant une forme diagonale.

10. Procédé de réalisation d'une cellule solaire flexible, ce procédé comprenant :
la réalisation (305, 405) d'une cellule solaire rigide (501), qui comprend un contact arrière interdigité (508) et un substrat collecteur de lumière (502), disposés en haut du contact arrière interdigité (508), **caractérisé par**
la formation (310, 425) d'une pluralité de canaux (118) dans le substrat collecteur de lumière (502), dans laquelle la pluralité de canaux (118) exposent des portions du contact arrière interdigité (508) et la pluralité de canaux (118) s'étendent dans une direction (116) perpendiculaire à une direction (110, 112) dans laquelle s'étendent les contacts du contact interdigité.

11. Procédé selon la revendication 10, dans lequel, avant la formation de la pluralité de canaux (118), ce procédé comprenant :
l'application d'une photo-résine sur les surfaces avant et arrière de la cellule solaire rigide (501) ; et
l'application d'un film dans la troisième direction sur la partie supérieure de la photo-résine sur les surfaces avant de la cellule solaire rigide.

12. Procédé selon la revendication 11, dans lequel, avant la formation de la pluralité de canaux (118), ce procédé comprenant en outre :
l'élimination des portions de la photo-résine non recouvertes par le film.

13. Procédé selon la revendication 11, comprenant en outre :
l'élimination du film après la formation de la pluralité de canaux (118).

14. Procédé selon la revendication 13, comprenant en outre :
le nettoyage de la photo-résine résiduelle de la cellule solaire après l'élimination du film.

15. Procédé selon la revendication 10, dans lequel le contact arrière interdigité (508) est constitué d'aluminium sérigraphié.
